Europäisches Patentamt

European Patent Office

Office européen des brevets

(11) Publication number: **0 398 244**
**A2**

# EUROPEAN PATENT APPLICATION

(21) Application number: 90109122.3

(22) Date of filing: 15.05.90

(51) Int. Cl.5: **G11C 11/407, G11C 11/409**

(30) Priority: 15.05.89 JP 121209/89

(43) Date of publication of application:
**22.11.90 Bulletin 90/47**

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Ohsawa, Takashi, c/o Intellectual**
**Property Div.**
**K.K. Toshiba, 1-1 Shibaura 1-chome**
**Minato-ku, Tokyo 105(JP)**

(74) Representative: **Lehn, Werner, Dipl.-Ing. et al**
**Hoffmann, Eitle & Partner Patentanwälte**
**Arabellastrasse 4**
**D-8000 München 81(DE)**

(54) Dynamic type random-acces memory.

(57) This invention discloses a dynamic type random-access memory which includes a bit line pair, a memory cell array including a plurality of memory cells ($MC_i$; i = 0 to 255), a bit line sense amplifier (NA, PA) which is enabled after data written in one of the plurality of memory cells ($MC_i$; i = 0 to 255) is read out onto the bit line pair, and a charge transfer circuit ($NT_1$, $NT_2$) which is connected between the bit line pair and sense nodes (SN, $\overline{SN}$) of the bit line sense amplifier (NA, PA), and is kept OFF for a predetermined period of time after a sense amplification operation of the bit line sense amplifier (NA, PA) is started.

F I G. 1

## Dynamic type random-access memory

The present invention relates to a semiconductor memory and, more particularly, to a semiconductor memory having a bit line potential read circuit portion in a dynamic type random-access memory (to be abbreviated to as a DRAM hereinafter).

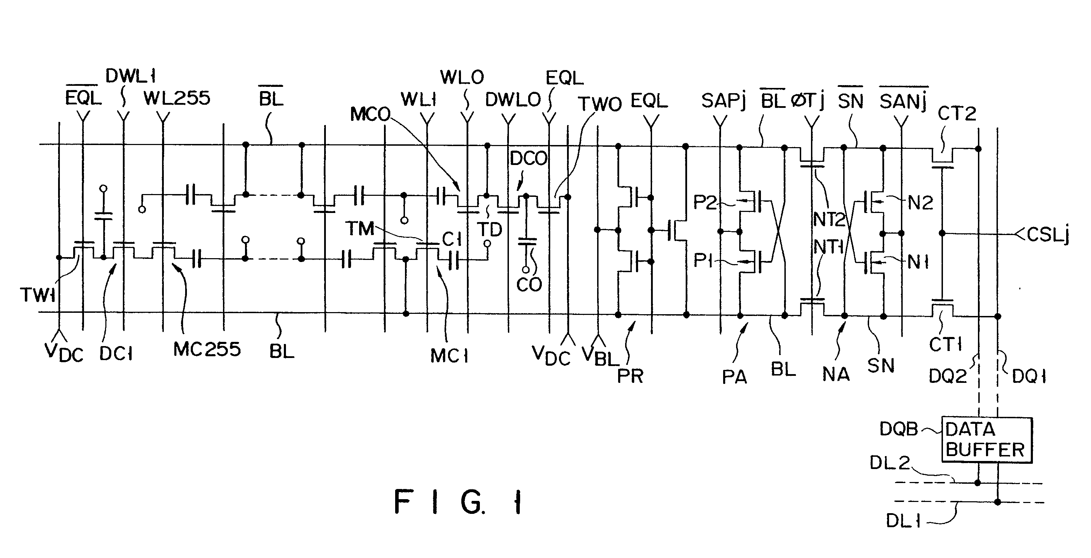

Since a conventional large-capacity DRAM sense-amplifies a potential difference between a bit line pair at high speed using a bit line sense amplifier in a read mode of memory cell data, charge transfer transistors $NT_1$ and $NT_2$ comprising insulating gate type MOS field effect transistors are connected between first and second bit lines BL and $\overline{BL}$ constituting the bit line pair of each column, and a bit line sense amplifier NA, as shown in Fig. 1.

In Fig. 1, reference symbols BL and $\overline{BL}$ denote first and second bit lines constituting the bit line pair of each column in a memory cell array of a DRAM. Reference symbol $MC_i$ (i = 0 to 255), ... denotes a plurality of dynamic type memory cells connected to the bit lines BL and $\overline{BL}$; $DC_0$ and $DC_1$, dummy cells respectively connected to the first and second bit lines BL and $\overline{BL}$; $WL_i$ (i = 0 to 255), ..., word lines respectively connected to the gates of charge transfer transistors TM of the memory cells $MC_i$; $DWL_0$ and $DWL_1$, dummy word lines respectively connected to the gates of charge transfer transistors TD of the dummy cells $DC_0$ and $DC_1$; and $TW_0$ and $TW_1$, dummy cell write transistors for writing a dummy cell write voltage $V_{DC}$ in the dummy cells $DC_0$ and $DC_1$. The transistors $TW_0$ and $TW_1$ are enabled by a precharge signal $\overline{EQ\,L}$ (bit line precharge dummy cell write signal).

Reference symbol PR denotes a precharge equalize circuit for precharging and equalizing the first and second bit lines BL and $\overline{BL}$ constituting the bit line pair of each column to a precharge voltage $V_{BL}$ (which is set to be, e.g., 1/2 a power source voltage $V_{CC}$). The precharge equalize circuit PR is enabled by the precharge signal $\overline{EQL}$. Reference symbol PA denotes a bit line restore p-channel sense amplifier comprising p-channel MOS transistors $P_1$ and $P_2$. The drain of the transistor $P_1$ is connected to the bit line BL, and the drain of the transistor $P_2$ is connected to the bit line $\overline{BL}$. The gate of the transistor $P_1$ is connected to the drain of the transistor $P_2$, and the gate of the transistor $P_2$ is connected to the drain of the transistor $P_1$. The sense amplifier PA is enabled by a p-channel sense amplifier enable signal $SAP_j$. Reference symbol NA denotes an n-channel sense amplifier comprising n-channel MOS transistors $N_1$ and $N_2$. The drain of the transistor $N_1$ is connected to a sense node SN, and the drain of the transistor $N_2$

is connected to a sense node $\overline{SN}$. The gate of the transistor $N_1$ is connected to the sense node $\overline{SN}$, and the gate of the transistor $N_2$ is connected to the sense node SN. The drain of the transistor $N_1$ is connected to one current path of the charge transfer transistor $NT_1$, and the drain of the transistor $N_2$ is connected to one current path of the charge transfer transistor $NT_2$. The sense amplifier NA is enabled by an n-channel sense amplifier enable signal $\overline{SAN_j}$.

The charge transfer transistors $NT_1$ and $NT_2$ receive a drive signal $\phi_{Tj}$ from a charge transfer transistor driver (not shown), and are controlled to be kept OFF for a predetermined period of time from a timing immediately before the n-channel sense amplifier NA is enabled.

The pair of sense nodes SN and $\overline{SN}$ of the bit line sense amplifier NA are connected to a pair of column selection transistors $CT_1$ and $CT_2$. The pair of column selection transistors $CT_1$ and $CT_2$ are respectively connected to a pair of data buses $DL_1$ and $DL_2$ through a pair of data lines $DQ_1$ and $DQ_2$ commonly connected to a plurality of columns and through a data buffer DQB.

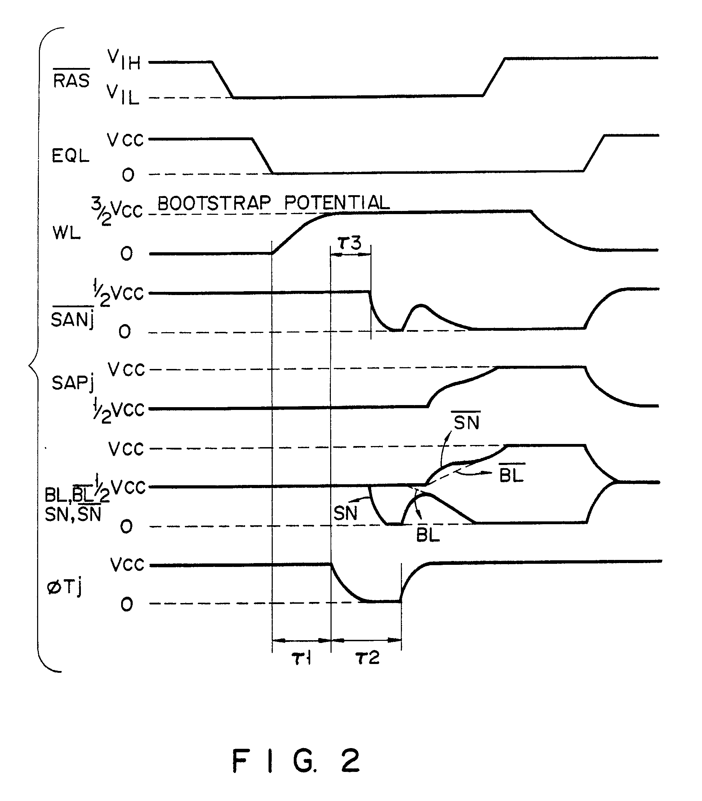

The operation of the conventional DRAM will be described below with reference to the waveforms shown in Fig. 2. In this case, read and rewrite operations from and to a memory cell $MC_1$ when a potential of data 0 V ("L" level) is written in the memory cell $MC_1$ connected to one of the bit line pair, e.g., the first line BL will be described below.

This DRAM employs a driving system wherein a $V_{CC}$ potential is, e.g., 5 V, and the bit line pair are precharged to a voltage of $V_{BL}$ = $V_{CC}/2$. Thus, during a period before a word line is selected, both the first and second bit lines BL and $\overline{BL}$ are kept at $V_{CC}/2$. When row and column addresses are sequentially input as address inputs, and a row address strobe signal $\overline{RAS}$ is enabled, a row address is written, and is determined in the memory chip. When the row address is determined, the row address is decoded, and the word line $WL_1$ on the side of the first bit line BL is selected to turn on the charge transfer transistor TM of the selected memory cell $MC_1$. Thus, the potential of data 0 V ("L" level) is read out from a capacitor $C_1$ of this memory cell $MC_1$, and the potential of the first bit line BL is slightly decreased from $V_{CC}/2$.

Meanwhile, when the word line $WL_1$ on the side of the first bit line BL is selected, the dummy word line $DWL_0$ on the side of the second bit line $\overline{BL}$ is simultaneously selected, thus turning on the charge transfer transistor TD of the dummy cell $DC_0$. Since a potential of $V_{DC}$ (e.g., $V_{CC}/2$) is written in advance in the dummy cell $DC_0$, even if the charge transfer transistor TD is turned on and a capacitor $C_0$ of the dummy cell $DC_0$ is short-circuited to the second bit line $\overline{BL}$, the potential of the second bit line $\overline{BL}$ is left unchanged at $V_{CC}/2$ since the capacitor C0 and the second bit line $\overline{BL}$ have the same potential.

As described above, after a delay time $\tau_1$ from when the data of the memory cell $MC_1$ appears on the first bit line BL until a small potential difference $\Delta V_{BL}$ appears between the first and second bit lines BL and $\overline{BL}$, the charge transfer transistor drive signal $\phi_{Tj}$ goes to a $V_{SS}$ potential for a predetermined period of time $\tau_2$, and the charge transfer transistors $NT_1$ and $NT_2$ are turned off for a predetermined period of time. As a result, the first and second bit lines BL and $\overline{BL}$ as the bit line pair are disconnected from the n-channel sense amplifier NA, i.e., are set in a floating state for a predetermined period of time. After a delay time $\tau_3$ until these charge transfer transistors $NT_1$ and $NT_2$ are completely turned off, the n-channel sense amplifier enable signal $\overline{SAN_j}$ goes to the $V_{SS}$ potential, thereby enabling the n-channel sense amplifier NA.

A small potential difference between the pair of first and second sense nodes SN and $\overline{SN}$ of the n-channel sense amplifier NA is sense-amplified by the n-channel sense amplifier NA. When the n-channel sense amplifier NA is enabled, the potential of the sense node SN of the n-channel sense amplifier NA is decreased to 0 V. Thereafter, when the signal $\phi_{Tj}$ is returned to the $V_{CC}$ potential and the charge transfer transistors $NT_1$ and $NT_2$ are returned from an OFF to ON state, the first and second bit lines BL and $\overline{BL}$ are respectively connected to the corresponding first and second sense nodes SN and $\overline{SN}$ of the n-channel sense amplifier NA, and the potential of the first bit line BL is decreased toward 0 V. Furthermore, the signal $SAP_j$ goes to the $V_{CC}$ potential to enable the p-channel sense amplifier PA, and the potential of the second bit line $\overline{BL}$ is increased toward $V_{CC}$ potential by the p-channel sense amplifier PA.

Thereafter, a column address strobe signal CAS is enabled, and a column address is decoded. Thus, when the pair of column selection transistors $CT_1$ and $CT_2$ are turned on, the potentials of the pair of sense nodes SN and $\overline{SN}$ of the sense amplifier NA are reamplified by the data buffer DQB through the pair of data lines $DQ_1$ and $DQ_2$, and the amplified potentials are output to the pair of data buses $DL_1$ and $DL_2$. After "L"-level data is rewritten in the selected memory cell $MC_1$ and "H"-level data is rewritten in the dummy cell $DC_0$, the word line $WL_1$ and the dummy word line $DWL_0$ are returned to a non-selected state. After the rewrite operation, the precharge signal EQL goes to the VCC potential, so that the bit lines BL and $\overline{BL}$ are precharged to a voltage of $V_{BL}$, and the dummy cells $DC_0$ and $DC_1$ are precharged to a voltage of $V_{DC}$.

In the above-mentioned DRAM, since the capacitive components of the first and second bit lines BL and $\overline{BL}$ are completely disconnected from the sense nodes SN and $\overline{SN}$ upon operation of the n-channel sense amplifier NA, the loads of the sense nodes SN and $\overline{SN}$ are considerably reduced, and high-speed sense-amplification is achieved.

However, it was found that the sense nodes SN and $\overline{SN}$ are weak against various unavoidable asymmetries, and S/N ratios of the sense nodes SN and $\overline{SN}$ are decreased, resulting an erroneous operation of the sense amplifier NA.

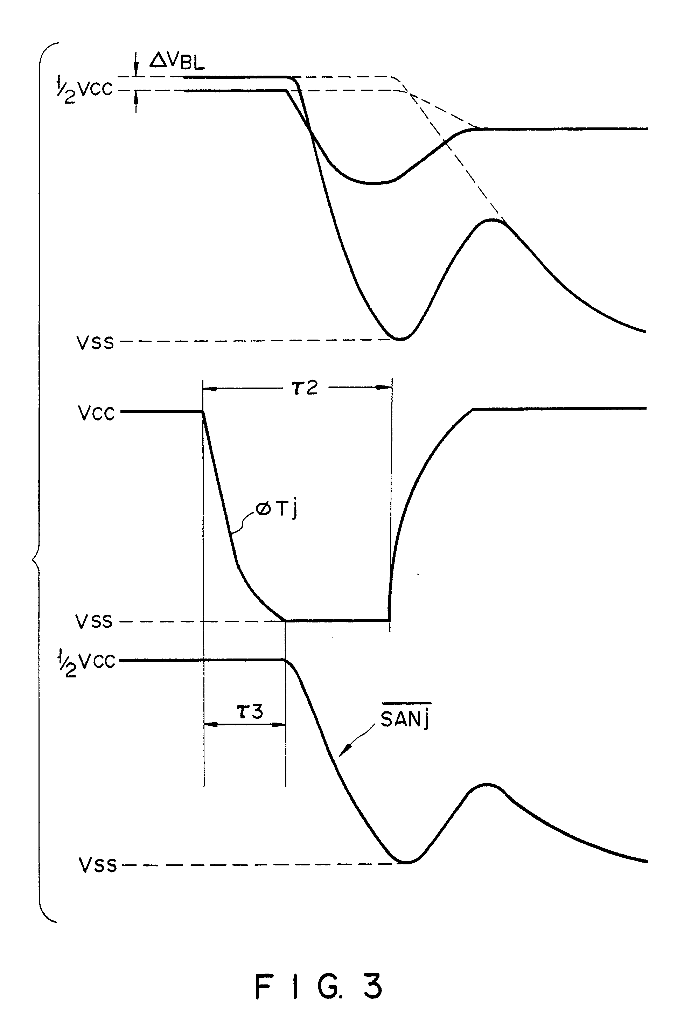

The erroneous operation will be described below with reference to Fig. 3 which shows in enlarged scales changes in potentials of the sense nodes SN and $\overline{SN}$, and changes in potentials of the first and second bit lines BL and $\overline{BL}$. The capacitances of the sense nodes SN and $\overline{SN}$ of the n-channel sense amplifier NA become very small since the charge transfer transistors $NT_1$ and $NT_2$ are turned off and the bit lines BL and $\overline{BL}$ are disconnected from the n-channel sense amplifier NA after the charge transfer transistor drive signal $\phi_{Tj}$ goes to the $V_{SS}$ potential. Thus, the capacitances of the sense nodes SN and $\overline{SN}$ become very sensitive to the asymmetry of the sense nodes SN and $\overline{SN}$ of the n-channel sense amplifier NA. Therefore, when the n-channel sense amplifier enable signal $SAN_j$ goes to the $V_{SS}$ potential, the relationship between the potentials of the sense nodes SN and $\overline{SN}$ may often be reversed under the influence of the asymmetry of the sense nodes SN and $\overline{SN}$. When the n-channel sense amplifier NA performs amplification in this reversed state, the potential of the sense node $\overline{SN}$ is erroneously decreased toward 0 V, resulting in an erroneous operation of the n-channel sense amplifier NA.

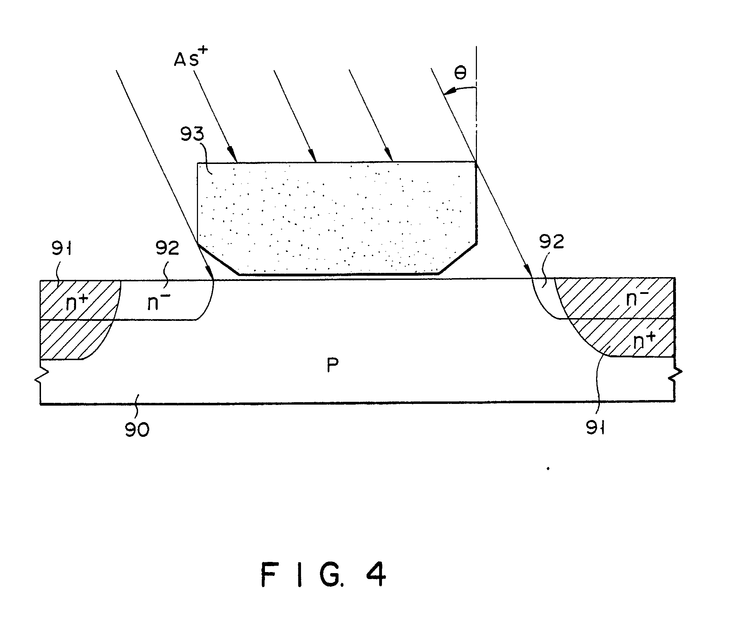

The asymmetry of the sense nodes SN and $\overline{SN}$ of the n-channel sense amplifier NA is mainly caused by oblique ion-implantation, as shown in Fig. 4, employed to form a low-concentration impurity region upon formation of an LDD (lightly doped drain) transistor if an n-channel transistor of an LDD structure is used as the n-channel transistor used in the n-channel sense amplifier NA. In Fig. 4, reference numeral 90 denotes a p-type silicon substrate; 91 and 92, a high-concentration impurity ($n^+$-type) region and a low-concentration impurity ($n^-$-type) region; and 93, a gate electrode formed of, e.g., polycrystalline silicon. When $As^+$ ions are vertically implanted in the surface of the silicon substrate 90, implanted impurity ions enter too deep in the silicon substrate 90, and a desired impurity profile cannot be formed. Thus, ion-implantation for forming the n⁻-type region 92 is normally performed to be inclined at $7°$ with respect to the surface of the silicon substrate 90. As a result, a portion where no ions are implanted is formed behind the gate electrode 93 and the LDD transistor has an asymmetrical shape, thus exhibiting asymmetrical electrical characteristics.

The asymmetry of the electrical characteristics can be reduced by performing ion-implantation while rotating the substrate 90 through $90°$ with respect to the first ion-implantation direction or forming a thin oxide film on the substrate 90 so as not to allow deep implantation of the impurity ions and then performing ion-implantation from a direction at an ion-implantation angle of $0°$. However, asymmetry to some extent inevitably occurs due to variations in manufacturing process. Therefore, a source-drain current varies depending on the selection of the two regions as the source and drain regions. Furthermore, a region shaded with the gate electrode has a small capacitance to the gate, and the other region has a large capacitance to the gate. Such asymmetry causes asymmetrical electrical characteristics of the LDD transistor described above.

As described above, a DRAM in which the charge transfer transistors are controlled to be turned off for a predetermined period of time from a timing immediately before the sense amplifier is enabled can perform high-speed sense amplification. However, when the first and second bit lines BL and $\overline{BL}$ are set in a floating state to reduce loads of the sense nodes, the DRAM is easily influenced by the asymmetry of the sense nodes of the sense amplifier, and the sense amplifier may easily cause an erroneous operation.

It is an object of the present invention to provide a DRAM which, even if asymmetry of sense nodes of a bit line sense amplifier unavoidably occurs, is not easily influenced by asymmetry of the sense nodes when loads of the sense nodes are reduced, can prevent an erroneous operation of the sense amplifier, and can perform high-speed sense amplification.

A DRAM according to the present invention comprises:
a bit line pair consisting of first and second bit lines;
a memory cell array including a plurality of memory cells connected to the bit line pair;
a precharge circuit for precharging the bit line pair to a predetermined voltage at a predetermined timing;
a bit line sense amplifier which is enabled after data written in one of the plurality of memory cells is read out onto the bit line pair; and
a charge transfer circuit which is connected between the bit lines and sense nodes of the bit line sense amplifier, and is kept OFF for a predetermined period of time after a sense amplification operation of the bit line sense amplifier is started.

In read and rewrite operations from and to a memory cell which is connected to, e.g., the first bit line and in which a potential of 0 V is written, both the first and second bit lines are equally kept at a bit line precharge voltage during a period from an enable timing of an $\overline{RAS}$ signal until a word line goes to selection level. When a word line is selected, data 0 V is read out from the selected memory cell, and the potential of the first bit line is slightly decreased from the bit line precharge voltage. Thus, when a small potential difference occurs between the potentials of the first and second bit lines, the bit line sense amplifier is enabled, and sense-amplifies the small potential difference between the first and second bit lines. Thus, the potential of the first sense node is decreased toward 0 V. Thereafter, the charge transfer circuit is turned off for a predetermined period of time, and the bit line pair are disconnected from the bit line sense amplifier for the predetermined period of time. After the potential of the first bit line is rewritten in the selected memory cell, the word line is returned to a non-selected state. Furthermore, a precharge signal is enabled, and the bit line pair are respectively precharged.

According to the DRAM of the present invention, since the charge transfer circuit is controlled to be kept OFF for a predetermined period of time after the bit line sense amplifier is enabled, a high-speed sense amplification operation is allowed immediately after the loads of the sense nodes are reduced. Even when asymmetry of the sense nodes of the bit line sense amplifier occurs unavoidably, the bit line sense amplifier has already been enabled when the loads of the sense nodes are reduced. Therefore, the capacitances of the sense nodes will not become too small, and the DRAM can be prevented from being easily influenced by the asymmetry and from causing an erroneous operation of the sense amplifier.

This invention can be more fully understood from the following detailed description when taken in conjunction with the accompanying drawings, in which:

Fig. 1 is a circuit diagram for explaining an operation of a conventional DRAM and a DRAM according to the present invention;

Fig. 2 is a waveform chart showing an operation of the conventional DRAM;

Fig. 3 is an enlarged waveform chart of Fig. 2;

Fig. 4 is a sectional view showing ion-implantation for forming a low-concentration impurity region in a manufacturing process of an n-channel transistor of an LDD structure used in a bit line sense amplifier shown in Fig. 1;

Fig. 5 is a schematic block diagram partially showing a drive signal supply system employing a charge transfer transistor driving system of a DRAM according to the present invention;

Fig. 6 is a waveform chart showing an operation of the DRAM according to the present invention;

Fig. 7 is a partially enlarged waveform chart of Fig. 6;

Fig. 8 is a circuit diagram showing a modification of the DRAM shown in Fig. 1; and

Figs. 9A and 9B are diagrams showing modifications of a charge transfer circuit.

An embodiment of the present invention will be described below with reference to the accompanying drawings.

Fig. 1 shows a portion of a DRAM according to the present invention. The DRAM of the present invention has a different OFF controlling timing of charge transfer transistors $NT_1$ and $NT_2$ as compared to a conventional DRAM which employs a charge transfer transistor driving system (a system in which the charge transfer transistors $NT_1$ and $NT_2$ are controlled to be kept OFF from a timing immediately before an n-channel sense amplifier is enabled) described above with reference to Fig. 2. More specifically, as compared to the conventional DRAM, according to this embodiment, an n-channel sense amplifier enable signal $\overline{SAN_j}$ is decreased to a $V_{SS}$ potential before a charge transfer transistor drive signal $\phi_{Tj}$ is decreased to the $V_{SS}$ potential. This embodiment has the same circuit arrangement as that of the prior art shown in Fig. 1, and this embodiment will be described below with reference to Fig. 1.

More specifically, according to the characteristic feature of the DRAM shown in Fig. 1, an n-channel sense amplifier NA is enabled after a signal is read out from a memory cell onto a bit line, and the charge transfer transistors $NT_1$ and $NT_2$ are controlled to be OFF after the sense amplification operation of the n-channel sense amplifier NA.

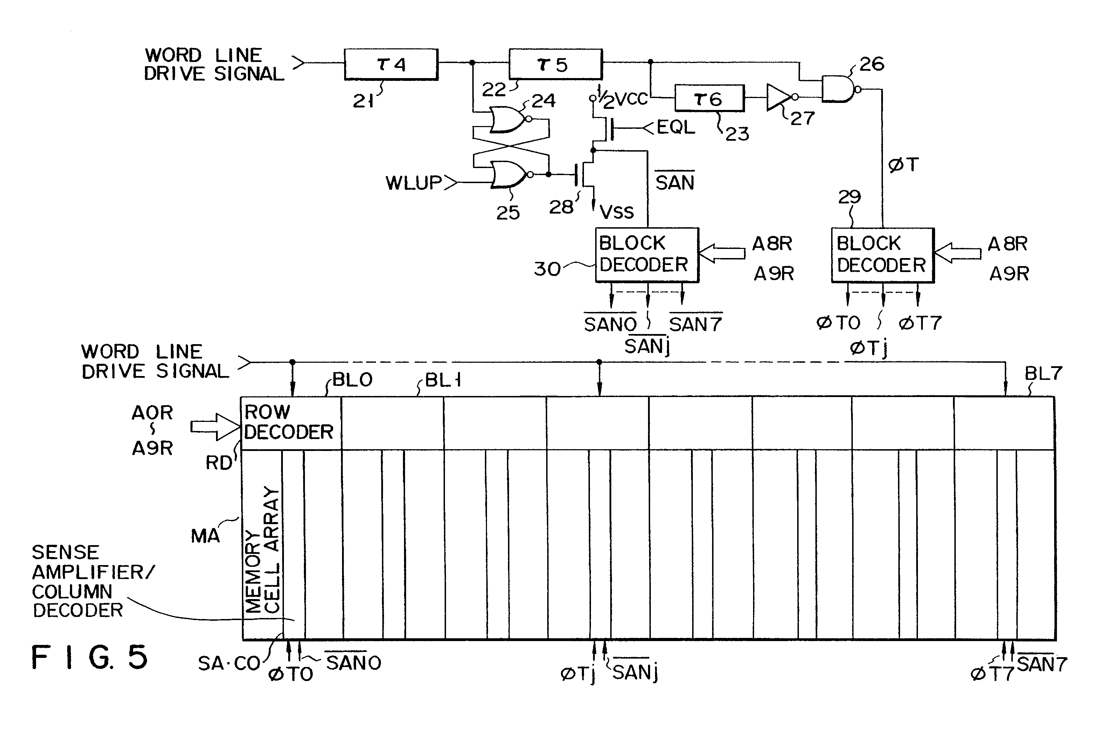

Fig. 5 schematically shows a portion of a drive signal supply system in, e.g., a 4-Mbit DRAM employing the above-mentioned charge transfer transistor driving system. A memory cell array MA is divided into eight blocks $BL_0$ to $BL_7$ in correspondence with combinations of upper three addresses $A_{8R}$, $A_{9R}$, and $A_{10R}$. A sense amplifier/column decoder SA•CD is arranged at a central portion in the column direction of each block (including 512K cells), and a row decoder RD is arranged at one end portion in a row direction of each block. In one cycle, two blocks can be simultaneously enabled. Reference numerals 21 to 23 denote delay circuits; 24 and 25, NOR gates; 26, a NAND gate; 27 and 28, inverters; and 29 and 30, block decoders.

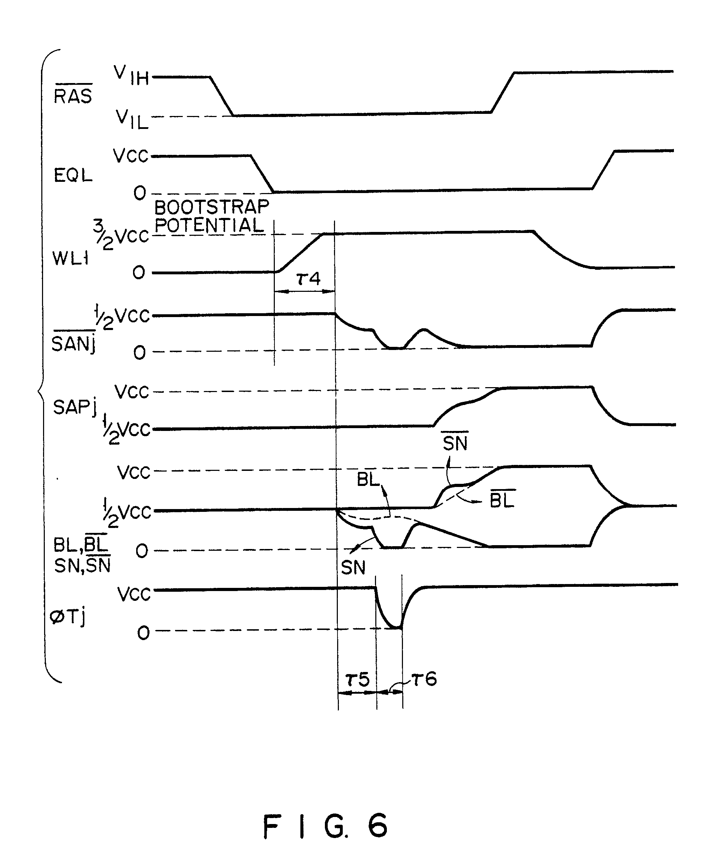

An operation of the DRAM will be described below with reference to waveforms shown in Fig. 6. In this case, read and rewrite operations from and to a memory cell $MC_1$ when a potential of data 0 V ("L" level) is written in the memory cell $MC_1$ connected to one of the bit line pair, e.g., a first line BL will be described below.

This DRAM employs a driving system wherein a $V_{CC}$ potential is, e.g., 5 V, and a bit line pair are precharged to a voltage of $V_{BL} = V_{CC}/2$. Thus, before a word line is selected, both first and second bit lines BL and $\overline{BL}$ are kept at $V_{CC}/2$. Row and column addresses are sequentially input as address inputs, and a row address strobe signal $\overline{RAS}$ is enabled after the row address is input. Thereafter, a precharge signal EQL is disabled. When the signal RAS is enabled, the row address is fetched, and is determined in the memory chip. Thus, the row address is decoded, and a word line $WL_1$ on the side of the first bit line BL is selected to turn on a charge transfer transistor TM of the selected memory cell $MC_1$. As a result, the potential of data 0 V ("L" level) is read out from a capacitor $C_1$ of this memory cell $MC_1$, and the potential of the first bit line BL is slightly decreased from $V_{CC}/2$.

When the word line $WL_1$ on the side of the first bit line BL is selected, a dummy word line $DWL_0$ on the side of the second bit line $\overline{BL}$ is selected to turn on a charge transfer transistor TD of a dummy cell $DC_0$. In this case, a potential of $V_{DC}$ (e.g., $V_{CC}/2$) is written in advance in the dummy cell $DC_0$. Therefore, when the charge transfer transistor TD is turned on and a capacitor $C_0$ of the dummy cell $DC_0$ is short-circuited to the second bit line $\overline{BL}$, the potential of the second bit line $\overline{BL}$ is left unchanged at $V_{CC}/2$ since the second bit line $\overline{BL}$ and the capacitor $C_0$ have the same potential. After a delay time $\tau_4$ from when the data of the memory cell $MC_1$ appears on the first bit line BL until a small potential difference $\Delta V_{BL}$ appears between the first and second bit lines BL and $\overline{BL}$, a control signal $\overline{SAN}$ is decreased to $V_{SS}$. Thus, the block decoder 29 decodes the two addresses $A_{8R}$ and $A_{9R}$, and two of sense amplifier enable signals $\overline{SAN_0}$ to $\overline{SAN_7}$ (one of these signals corresponds to an n-channel sense amplifier enable signal $\overline{SAN_j}$) selectively go to the $V_{SS}$ potential. The n-channel sense amplifier NA in the selected block are thus enabled to perform a sense amplification operation. As a result, the potential of its first sense node SN is decreased toward 0 V.

After a delay time $\tau_5$, a control signal $\phi_{Tj}$ is decreased to the $V_{SS}$ potential for a predetermined period of time $\tau_6$. Thus, the block decoder 30 decodes the two addresses $A_{8R}$ and $A_{9R}$, and two of charge transfer transistor drive signals $\phi_{T0}$ to $\phi_{T7}$ (one of these signals corresponds to a charge transfer transistor drive signal $\phi_{Tj}$) selectively go to the $V_{SS}$ potential only for the predetermined period of time $\tau_6$. The charge transfer transistors $NT_1$ and $NT_2$ in the selected block are turned off only for the predetermined period of time $\tau_6$. Thus, the bit lines BL and $\overline{BL}$ are disconnected from the n-channel sense amplifier NA for the predetermined period of time $\tau_6$. When the drive signal $\phi_{Tj}$ is recovered from the $V_{SS}$ potential to the $V_{CC}$ potential, and the charge transfer transistors $NT_1$ and $NT_2$ are returned from an OFF to ON state, the bit lines BL and $\overline{BL}$ are connected to the pair of sense nodes SN and $\overline{SN}$ of the bit line sense amplifier NA, and the potential of the first bit line BL is decreased to 0 V. Furthermore, a p-channel sense amplifier enable signal $SAP_j$ is changed from a $V_{CC}/2$ potential to the $V_{CC}$ potential to enable a p-channel sense amplifier PA, and the potential of the second bit line $\overline{BL}$ is increased toward the $V_{CC}$ potential by the p-channel sense amplifier PA.

After the sense amplification operation of the n-channel sense amplifier NA, a column address strobe signal $\overline{CAS}$ is enabled, and a column address is decoded to turn on column selection transistors $CT_1$ and $CT_2$. As a result, the potentials of the pair of sense nodes SN and $\overline{SN}$ of the sense amplifier NA are reamplified by a data buffer DQB via a pair of data lines $DQ_1$ and $DQ_2$, and the amplified potentials are output onto a pair of data buses $DL_1$ and $DL_2$.

After "L"-level data is rewritten in the selected memory cell and "H"-level data is rewritten in the dummy cell $DC_0$, the word line $WL_1$ and the dummy word line $DWL_0$ are returned to a non-selected state. Furthermore, a precharge signal EQL is enabled, so that the bit lines BL and $\overline{BL}$ are precharged to a voltage of $V_{BL}$, and the dummy cells $DC_0$ and $DC_1$ are precharged to a voltage of $V_{DC}$.

In the DRAM described above, when a small potential difference $\Delta V_{BL}$ occurs between the potentials of the first and second bit lines BL and $\overline{BL}$, the n-channel sense amplifier NA is enabled to perform a sense amplification operation. Thereafter, the charge transfer transistors $NT_1$ and $NT_2$ are turned off for a predetermined period of time, and the capacitances of the bit lines BL and $\overline{BL}$ are completely disconnected from the n-channel sense amplifier NA for the predetermined period of time. When the capacitances of the bit lines BL and $\overline{BL}$ are disconnected from the n-channel sense amplifier NA, the loads of the sense nodes SN and $\overline{SN}$ are immediately reduced. From this timing, a sensing speed of the sense node SN is remarkably increased, and high-speed sense amplification is allowed.

Even when asymmetry of the sense nodes SN and $\overline{SN}$ of the n-channel sense amplifier NA occurs unavoidably, since the n-channel sense amplifier NA has already been enabled when the loads of the sense nodes SN and $\overline{SN}$ are reduced, the capacitances of the sense nodes SN and $\overline{SN}$ will not become too small. Thus, the DRAM is not easily influenced by the asymmetry between the sense nodes SN and $\overline{SN}$, and the n-channel sense amplifier NA can be free from an erroneous operation.

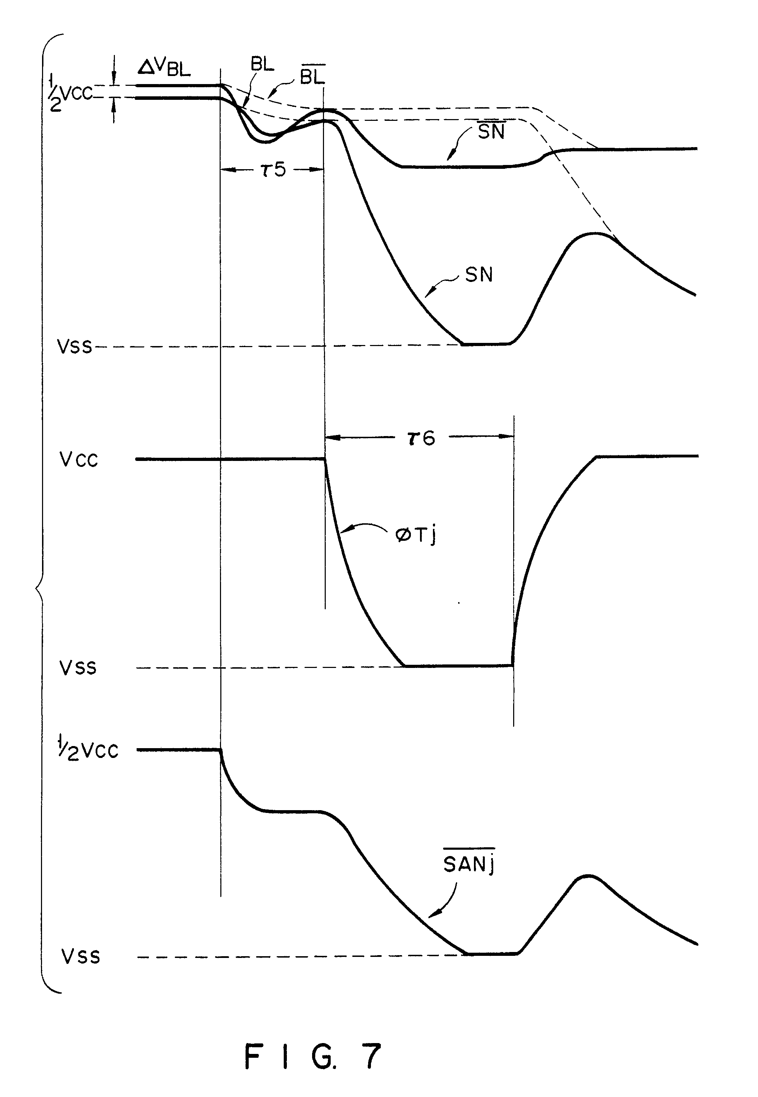

Changes in potentials of the sense nodes SN and $\overline{SN}$ and changes in potentials of the bit lines BL and $\overline{BL}$ will be described below with reference to Fig. 7 showing waveforms of Fig. 6 in enlarged scales. More specifically, when the n-channel sense amplifier enable signal $\overline{SAN_j}$ begins to fall toward the ground potential $V_{SS}$, the relationship between the potentials of the sense nodes SN and $\overline{SN}$ may often be reversed under the influence of the asymmetry of the sense nodes SN and $\overline{SN}$. That is, the potential of the sense node $\overline{SN}$ becomes lower than that of the sense node SN. At this time, however, since the charge transfer transistors $NT_1$ and $NT_2$ are not yet turned off by the charge transfer transistor drive signal $\phi_{Tj}$, after the lapse of a short period of time from when the n-channel sense amplifier enable signal $\overline{SAN_j}$ begins to fall toward the ground potential $V_{SS}$, the potentials of the sense nodes SN and $\overline{SN}$ are compensated for by charges on the bit lines BL and $\overline{BL}$ having larger capacitances, and approach those of the bit lines BL and $\overline{BL}$. Thus, the relationship between the potentials of the sense nodes SN and $\overline{SN}$ is reversed again, and the potential difference $\Delta V_{BL}$ between the first and second bit lines BL and $\overline{BL}$, which is almost equal to that at the beginning of activation, is recovered. After the lapse of a delay time $\tau_5$ from when the signal $\overline{SAN_j}$ begins to fall toward the ground potential $V_{SS}$, when the charge transfer transistor drive signal $\phi_{Tj}$ begins to fall toward the $V_{SS}$ potential for a predetermined period of time, the charge transfer transistors $NT_1$ and $NT_2$ are kept OFF only for a delay time $\tau_6$, and the bit lines BL and $\overline{BL}$ are disconnected from the n-channel sense amplifier NA for the predetermined period of time. When the bit lines BL and $\overline{BL}$ are disconnected from the sense amplifier NA, the loads of the sense nodes $\overline{SN}$ and are reduced, and high-speed sense amplification can be normally performed.

The delay time $\tau_5$ required from when the signal $\overline{SAN_j}$ begins to fall toward the ground potential $V_{SS}$ and the potential difference $\Delta V_{BL}$ almost equal to that at the beginning of activation is recovered to the sense nodes SN and $\overline{SN}$ is as short as 3 to 4 ns in the worst case since the capacitances of the sense nodes SN and $\overline{SN}$ are as very small as 100 fF or less and is negligible.

In this embodiment, when the charge transfer transistors $NT_1$ and $NT_2$ are turned off, the charge transfer transistor drive signal $\phi_{Tj}$ is decreased from $V_{CC}$ potential to the $V_{SS}$ potential. However, the signal may be decreased to an intermediate potential $V_M$ between the $V_{CC}$ and $V_{SS}$ potentials.

A DRAM which employs a charge transfer transistor driving system in which the charge transfer transistor drive signal $\phi_{Tj}$ is decreased to the intermediate potential $V_M$ when the charge transfer transistors $NT_1$ and $NT_2$ are turned off, will be described in detail below. The intermediate potential $V_M$ satisfies $V_{TN} \leq V_M \leq V_{BL} + V_{TN}$ where $V_{BL}$ is the bit line precharge potential and $V_{TN}$ is the threshold voltage of the n-channel charge transfer transistors $NT_1$ and $NT_2$, and $V_M$ is set to be, e.g., $V_{CC}/2 = 2.5$ V.

The read and rewrite operations with respect to this DRAM are performed according to the operations of the embodiment described above, except for the following operations. That is, when a signal is read out from a memory cell and a dummy cell, and the small potential difference $\Delta V_{BL}$ occurs between the potentials of the first and second bit lines BL and $\overline{BL}$, the n-channel sense amplifier NA is enabled to perform initial amplification. Thereafter, the signal $\phi_{Tj}$ is decreased from the $V_{CC}$ potential to the intermediate potential $V_M$ to turn off the charge transfer transistors $NT_1$ and $NT_2$. As a result, the bit lines BL and $\overline{BL}$ are disconnected from the n-channel sense amplifier NA.

When the potential difference between the intermediate potential $V_M$ and the first sense node SN exceeds $V_{TN}$, a potential difference between two terminals, i.e., the input terminal of the signal $\phi_{Tj}$ and the sense node SN is increased. Thus, since the impedance of the charge transfer transistor $NT_1$ is gradually decreased, the n-channel sense amplifier NA begins to transfer the charge on the first bit line BL, and the potential of the first bit line BL begins to decrease. As a result, since the charge on the first bit line BL begins to flow in the first sense node SN, the potential drop speed of the first sense node SN is suddenly decreased.

Thereafter, the potentials of the first sense node SN and the first bit line BL are decreased to 0 V while approaching each other. Thus, the potential of the first bit line BL is rewritten in the selected memory cell $MC_1$, and the potential of the second bit line $\overline{BL}$ is rewritten in the dummy cell $DC_0$.

Before completion of the above-mentioned rewrite operation (may be after completion), the signal $\phi_{Tj}$ is returned to the $V_{CC}$ potential, and the charge transfer transistors $NT_1$ and $NT_2$ are returned to an ON state. When the charge transfer transistors $NT_1$ and $NT_2$ are returned to the ON state, a charge is suddenly redistributed to the first sense node SN and the first bit line BL. In this case, although the potential of the first sense node SN having a smaller capacitance rises slightly earlier than that of the first bit line BL, the potentials of the first sense node SN and the first bit line BL are considerably close to each other, and the potential of the first sense node SN will not immediately rise.

In the read operation of the DRAM described above, when the charge on the first bit line BL begins to flow in the first sense node SN and the potential drop speed of the first sense node SN is suddenly decreased, the potential difference between the pair of sense nodes SN and $\overline{SN}$ is larger than $V_{TN}$ (when $V_M = V_{CC}/2$). In this state, therefore, even when the column selection transistors $CT_1$ and $CT_2$ are turned on, the potential difference between the sense nodes SN and $\overline{SN}$ is large enough to be reamplified by the data buffer DQB through the data lines $DQ_1$ and $DQ_2$, and high-speed access is allowed.

Even when the column selection transistors $CT_1$ and $CT_2$ are turned on when the potential of the first sense node SN rises slightly earlier than that of the first bit line BL, a decrease in high-speed operation power of the n-channel sense amplifier NA is small, and the sense amplifier NA can sufficiently transfer the charge on the data line $DQ_1$. As a result, an erroneous operation of the data buffer DQB can be prevented.

According to the DRAM employing the charge transfer transistor driving system in which the charge transfer transistor drive signal $\phi_{Tj}$ is decreased from the $V_{CC}$ potential to the $V_M$ potential, even when a time $t_{RAD}$ from an enable timing of the signal $\overline{RAS}$ to an input timing of a column address is shorter or longer than a predetermined range or falls within the range, the potentials of the sense nodes SN and $\overline{SN}$ of the n-channel sense amplifier NA have almost no increase when the signal $\overline{CAS}$ is enabled after the column address is input. Therefore, the data buffer DQB can normally perform reamplification.

In the above description, when the charge transfer transistor drive signal $\phi_{Tj}$ is decreased from the $V_{CC}$ potential to the intermediate potential $V_M$, the intermediate potential $V_M$ is set to satisfy $V_{TN} \leq V_M \leq V_{BL} + V_{TN}$. However, if the charge transfer transistors $NT_1$ and $NT_2$ are turned off at the beginning of the sense operation of the sense amplifier NA and are turned on before the sense amplifier NA completes a sense operation, the same effect as in the above embodiment can be obtained. Therefore, if a voltage necessary for turning on the column selection transistors $CT_1$ and $CT_2$ to cause the data buffer DQB to sense the potential is represented by $\alpha$ and a potential at which the sense node SN or $\overline{SN}$ begins to transfer the charge on the bit line BL or $\overline{BL}$ is represented by $\beta$, $V_M$ may be set to satisfy $V_{TN} + \beta \leq V_M \leq V_{BL} + V_{TN} - \alpha$.

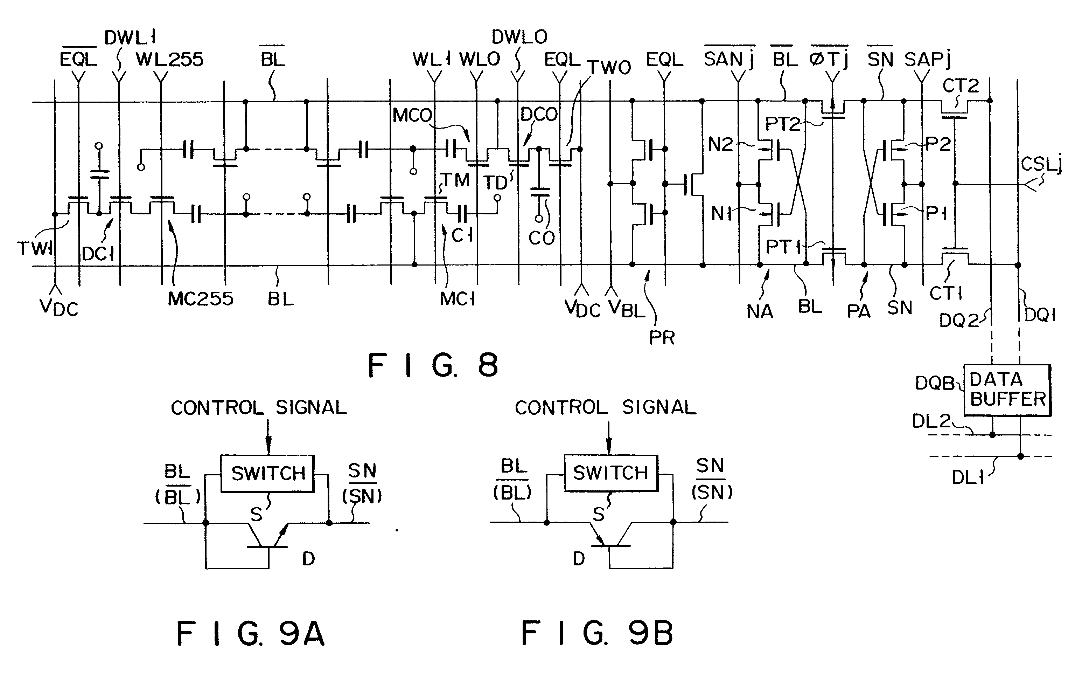

Fig. 8 shows a modification of the DRAM shown in Fig. 1. Differences between the DRAMs shown in Figs. 8 and 1 are that the n- and p-channel sense amplifiers NA and PA are replaced with each other, p-channel charge transfer transistors $PT_1$ and $PT_2$ are used in place of the n-channel charge transfer transistors $NT_1$ and $NT_2$, and the logic level of the charge transfer transistor drive signal $\overline{\phi_{Tj}}$ is inverted. Other arrangements are the same as those in Fig. 1, and the same reference numerals in Fig. 8 denote the same parts as in the above embodiment.

In this case, the charge transfer transistor drive signal $\overline{\phi_{Tj}}$ is increased from the $V_{SS}$ potential to the $V_{CC}$ potential or the intermediate potential $V_M$ when the charge transfer transistors $PT_1$ and $PT_2$ are turned off; otherwise, the signal is decreased to the $V_{SS}$ potential. The intermediate potential $V_M$ of the charge transfer transistor drive signal $\overline{\phi_{Tj}}$ is set to satisfy $V_{BL} - |V_{TP}| \leq V_M \leq V_{CC} - |V_{TP}|$ where $V_{BL}$ is the bit line precharge potential, and $V_{TP}$ is the threshold voltage of the p-channel charge transfer transistors $PT_1$ and $PT_2$.

The operation of the DRAM employing the charge transfer transistor driving system in which the charge transfer transistor drive signal $\overline{\phi_{Tj}}$ is increased from the $V_{SS}$ potential to the intermediate potential $V_M$ when the charge transfer transistors $PT_1$ and $PT_2$ are turned off is performed according to the operation of the DRAM employing the charge transfer transistor driving system in which the charge transfer transistor drive signal $\phi_{Tj}$ is decreased from the $V_{CC}$ potential to the intermediate potential $V_M$, and the same effect as described above can be obtained.

More specifically, when the charge begins to flow in from the second sense node $\overline{SN}$ to the second bit line $\overline{BL}$ and the potential rise speed of the second sense node $\overline{SN}$ is suddenly decreased, the potential difference between the pair of sense nodes SN and $\overline{SN}$ is larger than $|V_{TP}|$ (when $V_M = V_{CC}/2$). In this state, therefore, even when the column selection transistors $CT_1$ and $CT_2$ are turned on, the potential difference between the sense nodes SN and $\overline{SN}$ is large enough to be reamplified by the data buffer DQB through the data lines $DQ_1$ and $DQ_2$, and high-speed access is allowed.

When the charge transfer transistor $PT_2$ is returned to an ON state, a charge is immediately redistributed to the second sense node $\overline{SN}$ and the second bit line $\overline{BL}$, and the potential of the second sense node $\overline{SN}$ having a smaller capacitance falls slightly earlier than that of the second bit line $\overline{BL}$. However, even when the column selection transistors $CT_1$ and $CT_2$ are turned on in this state, a decrease in high-speed operation power of the p-channel sense amplifier PA is small, and an erroneous operation of the data buffer DQB can be prevented.

In the description associated with the modification shown in Fig. 8, the relationship among the bit line precharge voltage $V_{BL}$, the threshold voltage $V_{TP}$ of the p-channel charge transfer transistors $PT_1$ and $PT_2$, and the intermediate potential $V_M$ is determined to satisfy $V_{BL} - |V_{TP}| \leq V_M \leq V_{CC} - |V_{TP}|$. However, if the charge transfer transistors $PT_1$ and $PT_2$ are turned off at the beginning of the sense operation of the sense amplifier PA and are turned on before the sense amplifier PA completes a sense operation, the same effect as in the above embodiment can be obtained. Therefore, if a voltage necessary for turning on the column selection transistors $CT_1$ and $CT_2$ to cause the data buffer DQB to sense the potential is represented by $\alpha$ and a potential at which the sense node SN or $\overline{SN}$ begins to transfer the charge on the bit line BL or $\overline{BL}$ is represented by $\beta$, the relationship among the bit line precharge voltage $V_{BL}$, the threshold voltage $V_{TP}$ of the p-channel charge transfer transistors $PT_1$ and $PT_2$, and the intermediate potential VM may be set to satisfy $V_{BL} - |V_{TP}| + \alpha \leq V_M \leq V_{CC} - |V_{TP}| - \beta$.

In the DRAM employing the charge transfer transistor driving system in which the charge transfer transistor drive signal $\phi_{Tj}$ is decreased from the $V_{CC}$ potential to the intermediate potential $V_M$ or the charge transfer transistor drive signal $\overline{\phi_{Tj}}$ is increased from the $V_{SS}$ potential to the intermediate potential $V_M$, the charge transfer transistors $NT_1$ and $NT_2$ or $PT_1$ and $PT_2$ need not always be connected between the pair of bit lines BL and $\overline{BL}$ and the pair of sense nodes SN and $\overline{SN}$. For example, a charge transfer circuit having characteristics equivalent to the above-mentioned charge transfer transistors may be connected.

The charge transfer circuit can be controlled to be temporarily turned off when a small potential difference occurs between the bit lines BL and $\overline{BL}$ in a read mode of memory cell data. In the charge transfer circuit, the impedance is changed according to a potential difference between two terminals of bit lines and sense nodes as in the above-mentioned charge transfer transistors, and an element is connected between a bit line side terminal and a bit line sense amplifier side terminal. This element is turned off by a potential difference between a third terminal and one of the two terminals. Thus, when the element is turned off at the beginning of activation of the bit line sense amplifier to disconnect the sense nodes SN and $\overline{SN}$ from the bit lines BL and $\overline{BL}$ and a predetermined potential difference or more occurs between the pair of sense nodes SN and $\overline{SN}$, the impedance of the charge transfer circuit is gradually decreased, so that the sense nodes and the bit lines can be naturally and slowly connected to each other. As a result, a high-speed sense operation can be assured, and a temporary decrease in potential difference between the sense nodes SN and $\overline{SN}$ when the charge transfer circuit is returned to an ON state can be suppressed.

Figs. 9A and 9B show other charge transfer circuits. For example, a diode D comprising a bipolar NPN transistor whose collector and base are connected to each other is connected between two terminals, and a switching circuit S is connected in parallel with the diode D, and the switching circuit S is switching-controlled. When the switching circuit S is turned off at the beginning of activation of the bit line sense amplifier, the pair of sense nodes SN and $\overline{SN}$ are disconnected from the bit lines BL and $\overline{BL}$. When a predetermined potential difference or more occurs between the sense nodes SN and $\overline{SN}$, the impedance of the diode D is gradually decreased, and the potential differences between the bit lines BL and $\overline{BL}$ and between the sense nodes SN and $\overline{SN}$ are amplified. When the switching circuit S is turned on again, the potential difference between the bit lines BL and $\overline{BL}$ can be sufficiently increased.

Reference signs in the claims are intended for better understanding and shall not limit the scope.

## Claims

1. A dynamic type random-access memory comprising:
a bit line pair consisting of first and second bit lines (BL, $\overline{BL}$);
a memory cell array including a plurality of memory cells ($MC_i$) connected to said bit line pair;
a precharge circuit (PR) for precharging said bit line pair to a predetermined voltage at a predetermined timing;
a bit line sense amplifier (NA, PA) which is enabled after data written in one of said plurality of memory cells ($MC_i$) is read out onto said bit line pair; and
a charge transfer circuit ($NT_1$, $NT_2$, $PT_1$, $PT_2$, S, D) which is connected between said bit line pair and sense nodes (SN, $\overline{SN}$) of said bit line sense amplifier (NA, PA), and is kept OFF for a predetermined period of time after a sense amplification operation of said bit line sense amplifier (NA, PA) is started.

2. A memory according to claim 1, characterized in that an impedance of said charge transfer circuit ($NT_1$, $NT_2$, $PT_1$, $PT_2$, S, D) is changed when a potential difference between a first terminal of said bit line pair (BL, $\overline{BL}$) and a second terminal of said sense nodes (SN, $\overline{SN}$) is changed, said charge transfer circuit is turned off when a potential difference between a third terminal and one of the first and second terminals exceeds a predetermined value, and is controlled to be in an OFF state after said bit line sense amplifier (NA, PA) starts the sense amplification operation.

3. A memory according to claim 1, characterized in that said charge transfer circuit ($NT_1$, $NT_2$, $PT_1$, $PT_2$, S, D) comprises a field effect transistor, a source and a drain of which are connected to the first and second terminals, and a gate of which is connected to the third terminal, the gate being supplied with a charge transfer transistor drive signal from the third terminal.

4. A memory according to claim 3, characterized in that said field effect transistor comprises an n-channel MOS transistor ($NT_1$, $NT_2$) which is turned off when the charge transfer transistor drive signal supplied to the gate is decreased from a power source potential to an intermediate potential between the power source potential and a ground potential, and is turned on when the charge transfer transistor drive signal is increased from the intermediate potential to the power source potential.

5. A memory according to claim 3, characterized in that said field effect transistor comprises a p-channel MOS transistor ($PT_1$, $PT_2$) which is turned off when the charge transfer transistor drive signal supplied to the gate of increased from a ground potential to an intermediate potential between the ground potential and a power source potential, and is turned on when the charge transfer transistor drive signal is decreased from the intermediate potential to the ground potential.

6. A memory according to claim 1, characterized in that said charge transfer circuit (S, D) comprises a parallel circuit of a switching circuit (S) and a diode (D), and switching-controls said switching circuit (S).

F I G. 1

EP 0 398 244 A2

F I G. 2

FIG. 3

As$^+$

θ

93

91    92

n$^+$    n$^-$

92

n$^-$

n$^+$

P

90

91

F I G. 4

F I G. 5

EP 0 398 244 A2

F I G. 6

F I G. 7

F I G. 8

F I G. 9A

F I G. 9B

EP 0 398 244 A2